(19) **Europäisches Patentamt / European Patent Office / Office européen des brevets**

(11) **EP 1 858 159 B1**

(12) **EUROPEAN PATENT SPECIFICATION**

(45) Date of publication and mention
of the grant of the patent:
**21.09.2011 Bulletin 2011/38**

(51) Int Cl.:
**H03F 3/217** $^{(2006.01)}$

(21) Application number: **06114227.9**

(22) Date of filing: **19.05.2006**

(54) **Apparatus and method for performing a calculation operation**

Vorrichtung und Verfahren zur Durchführung von Rechenoperationen

Appareil et procédé de réalisation d'une opération de calcul

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**21.11.2007 Bulletin 2007/47**

(73) Proprietor: **CAMCO Produktions- und Vertriebs GmbH**
**57482 Wenden-Gerlingen (DE)**

(72) Inventors:
• **Schulze, Thomas**
**97080 Würzburg (DE)**

• **Wegner, Carsten**
**57072 Siegen (DE)**

(74) Representative: **Charles, Glyndwr**
**Reinhard, Skuhra, Weise & Partner GbR**
**Patent- und Rechtsanwälte**
**Friedrichstrasse 31**
**80801 München (DE)**

(56) References cited:
**EP-A- 1 653 604        EP-A- 1 653 605**
**US-A- 5 592 559        US-A- 5 617 058**
**US-B1- 6 473 457       US-B2- 6 586 991**

## Description

The invention relates to an apparatus and a method for performing a calculation operation with at least one input signal consisting of signal sections, wherein each signal section has a constant amplitude.

## TECHNICAL BACKGROUND

In many applications there is a need to perform mathematical operations with two-dimensional continuous time signals, such as pulse-width modulated signals. In a two-dimensional continuous time signal the information is encoded into the amplitude as well as into the time location of signal edges of the continuous time signal. A mathematical operation with such signals becomes, for instance, necessary when such a signal is fed back and subtracted from an input signal to close a feedback loop.

There are many different kinds of continuous time signals having at least two discrete amplitude values.

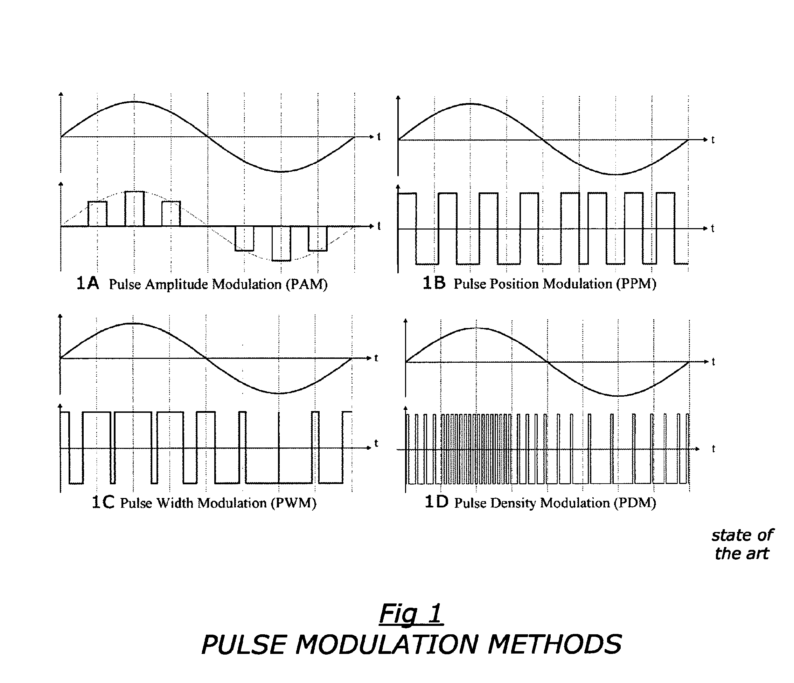

Figure 1 shows four basic pulse modulation techniques according to the state of the art, i. e. pulse amplitude modulation (PAM), pulse-width modulation (PWM), pulse position modulation (PPM) and pulse density modulation (PDM).

Pulse-width modulation is different from PAM in that it provides information in time whereas PAM provides the information in the amplitude. The pulse-width modulated signal as shown figure 1C has two discrete amplitude values. However, there are more complex pulse-width modulated signals, such as phase-shift carrier pulse-width modulated signals having, for example, four amplitude values. In a phase-shift carrier pulse-width modulated signal the information is encoded into discrete amplitude values and into the time location of signal edges of the continuous time signal.

The pulse position modulation (PPM) differs from pulse-width modulation in that the value of each instantaneous sample of a modulation wave causes the variation of the position in time of a pulse relative to its non-modulated time of a occurrence as shown in figure 1B.

Pulse density modulation PDM as shown in figure 1D is based on a unity pulse width, height in a constant time of occurrence for the pulse width in the switching period. The modulated parameter is the presence of the pulse. For each sample interval it is determined if the pulse should be present or not, i. e. the density of the pulses is modulated.

Any of the continuous time signals described above can be varied in such that the information is encoded into the time location of the signal edges and into the amplitude values by providing more than two discrete amplitude values.

Prior art documents EP1653604, EP1653605, US6586991, US5592559, US5617058, and US6473457 disclose various signal processing for class D amplifiers.

It is one aspect of the invention to provide an apparatus and a method for performing a calculation operation minimizing the non-linear distortions of the calculated output signal.

## SUMMARY OF THE INVENTION

The invention provides an apparatus for performing a calculation operation with at least one input signal consisting of signal sections, wherein each signal section of the input signal has a constant amplitude, according to claim 1.

In a preferred embodiment of the apparatus according to the present invention the input signal is a two-dimensional continuous time signal with at least two discrete amplitude values, wherein the information is encoded into the amplitude and into the time location of signal edges of said continuous time signal.

In a preferred embodiment of the apparatus according to the present invention the first intermediary signal is a one-dimensional continuous time signal with a virtual amplitude wherein the information carried by said two-dimensional input signal is encoded into the virtual amplitude of the first intermediary signal.

In a preferred embodiment of the apparatus according to the present invention the second intermediary signal is a one-dimensional continuous time signal with a virtual amplitude.

In a preferred embodiment of the apparatus according to the present invention the calculation unit receives the first intermediary signal from said signal transformation unit and performs the calculation operation with the first intermediary signal and, if appropriate, with one or more further input signals.

In a preferred embodiment of the apparatus according to the present invention the further input signal consists of signal sections, wherein each signal section of the further input signal has a constant amplitude.

In a preferred embodiment of the apparatus according to the present invention the further input signal is a one-dimensional continuous time signal.

In a preferred embodiment of the apparatus according to the present invention the signal transformation unit comprises a carrier signal generator for each carrier signal to generate the carrier signal.

In a preferred embodiment of the apparatus according to the present invention the signal transformation unit further comprises a comparator for each carrier signal generator which compares the amplitude of the input signal with the amplitude of the generated carrier signal to generate a logical output signal indicating whether the amplitude of the input signal is higher than the amplitude of the carrier signal.

In a preferred embodiment of the apparatus according to the present invention the signal transformation unit further comprises a sample-and-hold circuit for each comparator which is triggered by the logical output signal of the respective comparator to store temporarily the amplitude of the respective carrier signal at an output terminal of the sample-and-hold circuit.

In a preferred embodiment of the apparatus according to the present invention the sample-and-hold circuit is triggered by a rising edge or a by falling edge of the logical signal output at an output terminal of the respective comparator.

In a preferred embodiment of the apparatus according to the present invention the signal transformation unit further comprises a detector circuit which is connected to the output terminals of the comparators and receives the logical output signal of the comparators to detect which carrier signal has caused a rising edge or a falling edge of a logical output signal.

In a preferred embodiment of the apparatus according to the present invention the signal transformation unit further comprises a multiplexer which is controlled by the detector circuit and which has several inputs connected to the output terminals of the sample-and-hold circuit.

In a preferred embodiment of the apparatus according to the present invention the temporarily stored amplitude of the carrier signal detected by the detector circuit is switched by the multiplexer through as a first intermediary signal to the calculation unit.

In a preferred embodiment of the apparatus according to the present invention each carrier signal generator generates a periodic triangular signal.

In an alternative embodiment of the apparatus according to the present invention each carrier signal generator generates a periodic saw tooth signal.

In a preferred embodiment of the apparatus according to the present invention the carrier signal generator is formed by a counter.

In a preferred embodiment of the apparatus according to the present invention the generated carrier signals are phase shifted with respect to each other.

In a preferred embodiment of the apparatus according to the present invention the phase shift between two carrier signals is 360° divided by a number N of provided carrier signals.

In a preferred embodiment of the apparatus according to the present invention the calculation unit is a subtractor for subtracting a feedback signal from said first intermediary signal to generate the second intermediary signal.

In a preferred embodiment of the apparatus according to the present invention the calculation unit performs a selectable calculation operation.

In a preferred embodiment of the apparatus according to the present invention the input signal is generated by a signal source.

In a preferred embodiment of the apparatus according to the present invention the signal source generates the input signal in response to an analogue signal.

In a preferred embodiment of the apparatus according to the present invention the signal source generates the input signal in response to a PCM signal.

The invention further provides a corresponding method.

The invention further provides a corresponding computer program.

The invention further provides a data carrier for storing the computer program.

BRIEF DESCRIPTION OF THE DRAWINGS

Figures 1A-1D show signal diagrams of conventional continuous time signals;

Figure 2 shows a block diagram of a preferred embodiment of the calculation apparatus according to the present invention;

Figure 3 shows a block diagram of a preferred embodiment of a signal source;

Figure 4 shows a block diagram of a preferred embodiment of a signal transformation unit within an apparatus according to the present invention;

Figure 5 shows a signal diagram for illustrating the functionality of an apparatus according to the present invention;

Figure 6 shows a bock diagram of a preferred embodiment of a signal retransformation unit within an apparatus according to the present invention;

Figure 7 shows a typical use of an apparatus according to the present invention within a power amplifier;

Figure 8 shows a block diagram of a pulse modulator within the calculation apparatus according to the present invention provided within the power amplifier as shown in figure 7;

Figure 9 shows a block diagram of a PCM/PWM converter as employed within the calculation apparatus as shown in figure 7;

Figure 10 shows a flowchart of a preferred embodiment of the method according to the present invention.

DETAILED DESCRIPTION OF THE DRAWINGS

In the following, preferred embodiments of the apparatus and the method for performing a calculation operation are described with reference to enclosed figures.

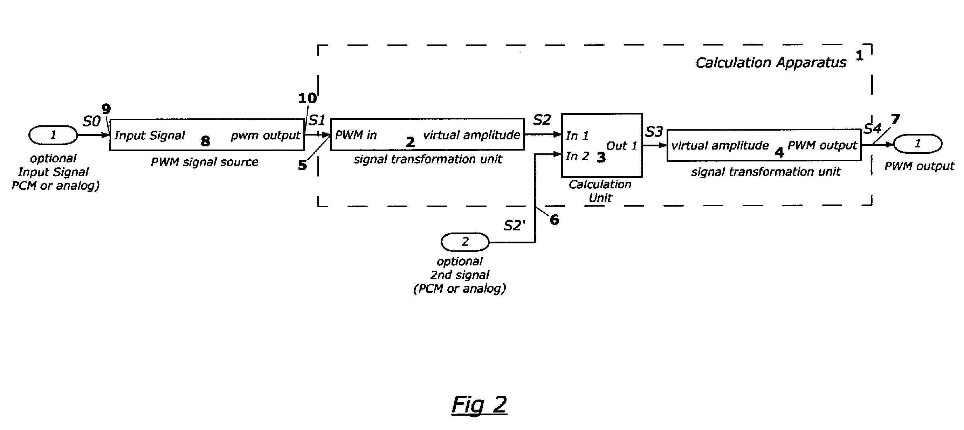

As can be seen from figure 2, the calculation apparatus 1 according to the present invention consists of a signal transformation unit 2 for transforming an input

signal $S_1$ into a first intermediary signal $S_2$, a calculation unit 3 for performing a calculation operation on the first intermediary signal $S_2$ to generate a second intermediary signal $S_3$ and a signal retransformation unit 4 for retransforming the second intermediary signal $S_3$ output by the calculation unit 3 into an output signal $S_4$. The calculation apparatus 1 comprises in a preferred embodiment a first input 5 for receiving a first input signal $S_1$ and a second input 6 for receiving a second input signal $S_{2'}$. The output signal generated by the signal retransformation unit 4 is output at an output terminal 7 of the calculation apparatus 1. The input signal $S_1$ applied to the first input terminal 5 of the calculation apparatus 1 is a two-dimensional continuous time signal with at least two discrete amplitude values wherein the information is encoded into an amplitude and into the time location of signal edges of the continuous time signal. This input signal is, for instance, a pulse-width modulated signal having at least two discrete amplitude values. The input signal can also be a pulse-density modulated signal or a pulse-position modulated signal. The signal transformation unit 2 transforms the input signal $S_1$ into the first intermediary signal $S_2$ which has a virtual amplitude with respect to at least one carrier signal. The calculation unit 3 performs a calculation operation of the transformed first intermediary signal $S_2$ output by the signal transformation unit 2 to generate the second intermediary signal $S_3$ which is supplied to the signal retransformation unit 4. The signal retransformation unit 4 retransforms the second intermediary signal $S_3$ into the output signal $S_4$ which consists of signal sections, wherein each signal section of the output signal $S_4$ has a constant amplitude. The output signal $S_4$ is, for example, also a pulse-width modulated signal. In an alternative embodiment, the output signal $S_4$ is formed by a pulse-density modulated signal or a pulse-position modulated signal.

The input signal $S_1$ can be applied directly to the calculation apparatus 1 as shown in figure 2 or is generated by a signal source 8 in response to an analogue or a PCM signal $S_0$.

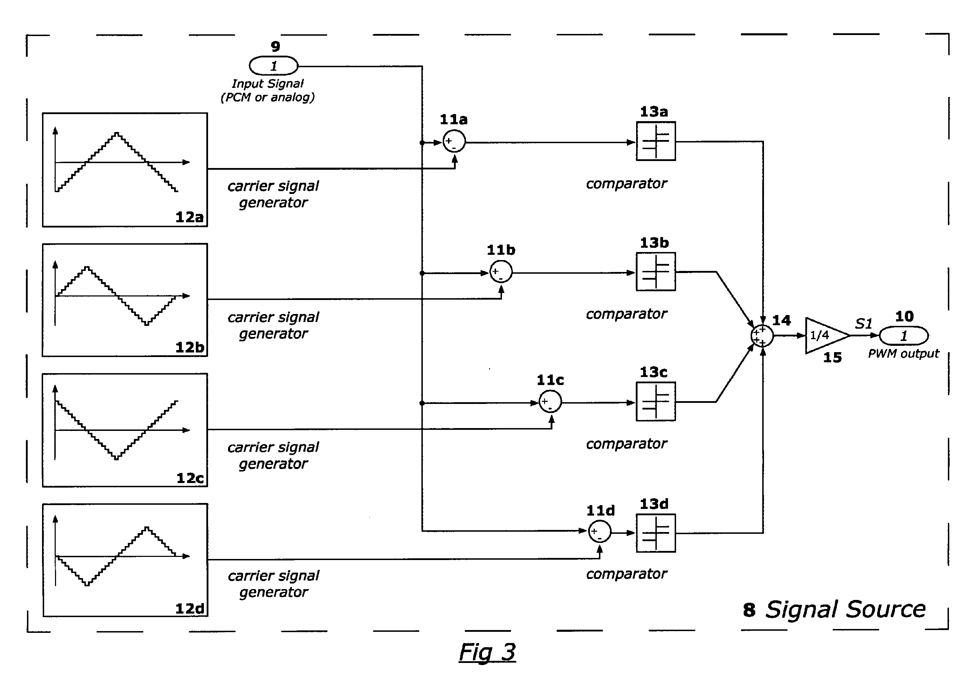

A possible embodiment of a signal source 8 is shown in figure 3. The signal source 8 has a signal input 9 and a signal output 10. An analogue input signal or a PCM input signal is applied to the input terminal and then applied to four subtractors 11a, 11b, 11c, 11d as shown in figure 3. The signal source 8 as shown in figure 3 is a signal source for generating a phase shifted carrier signal by means of four carrier signals generated by carrier signal generators 12a, 12b, 12c, 12d. The carrier signals are, for instance, triangular signals or saw tooth signals. Each carrier signal is phase shifted with respect to the other carrier signals. The phase shift is, for instance, 360° divided by a number N of provided carrier signals. In this shown embodiment, the number of carrier signals is N = 4. From the applied input signal, the different carrier signals are subtracted by means of the subtractors lla-lld and the respective difference signal is compared by a corresponding comparator 13a-13d with a threshold value, e. g. with a threshold value 0. The generated pulse-width modulated signals are superimposed with each other by means of an adder 14 and scaled by a scaling factor 0.25 by a scaling unit 15. The phase shift carrier signal with four discrete amplitude values is output by the PWM signal source 8 via an output terminal 10 to the input terminal 5 of the calculation apparatus 1 according to the present invention. The input signal $S_1$ is in any case a two-dimensional continuous time signal having at least two discrete amplitude values wherein the information is encoded in both, in the amplitude and into the time location of the signal edges.

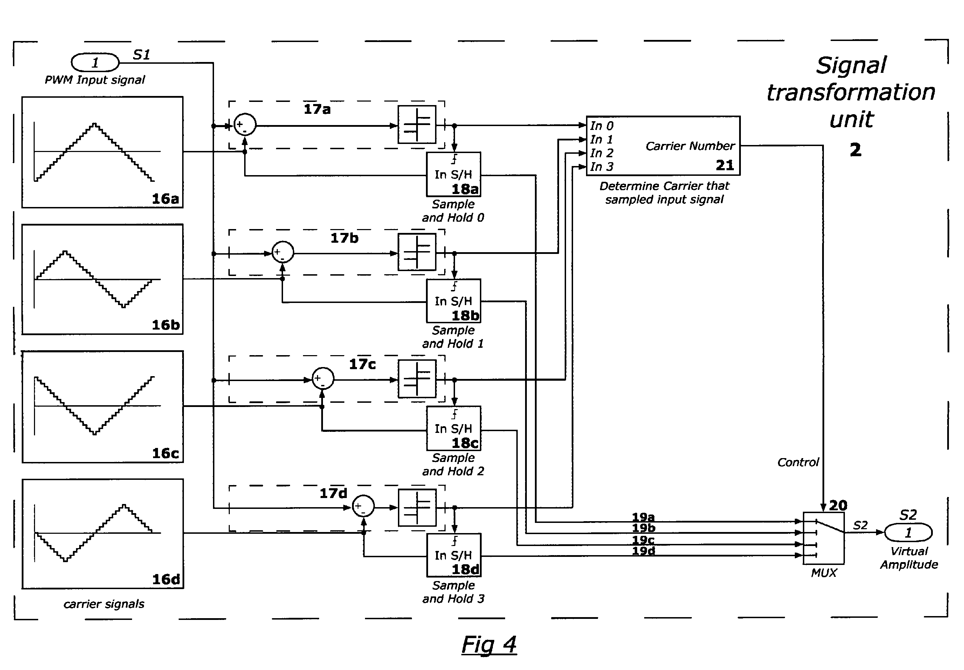

A preferred embodiment of the signal transformation unit 2 of the calculation apparatus 1 according to the present invention is shown in figure 4. The signal transformation unit 2 transforms the input signal $S_1$ into a first intermediary signal $S_2$ having a virtual amplitude with respect to at least one carrier signal. In this shown embodiment, the signal transformation unit 2 comprises four carrier signal generators 16a, 16b, 16c, 16d each generating a carrier signal. In one embodiment, the carrier signals are triangular signals. In alternative embodiments, the carrier signals have saw tooth form. The carrier signals comprise a phase shift of 360° divided by a number of carrier signal generators N = 4. The signal transformation unit 2 comprises a comparator 17 for each carrier signal generator as shown in figure 4. Each comparator 17 comprises a subtractor to subtract the carrier signal from the received input signal and a comparator comparing the difference signal with a threshold value 0. The comparator 17 compares the amplitude of the input signal which consists of signal sections, wherein each signal section has a constant amplitude, with the amplitude of the generated carrier signal to generate a logical output signal indicating whether the amplitude of the input signal is higher than the amplitude of said carrier signal. The signal transformation unit 2 comprises for each comparator 17 a corresponding sample-and-hold circuit 18 which is triggered by the logical output signal of the respective comparator 17 to store temporarily the amplitude of the respective carrier signal at an output terminal of the sample-and-hold circuit 18. The sample-and-hold circuit 18 is triggered by a rising edge or by a falling edge of the logical signal output by an output terminal of the respective comparator 17. The output terminals of the sample-and-hold circuits 18 are connected via lines 19 to input terminals of a multiplexer 20 which receives a control signal from a detector circuit 21. The detector circuit 21 is connected to the output terminal of the comparators 17 and receives the logical output signals of these comparators 17 to detect which carrier signal has caused a rising edge or a falling edge in the logical output signal. The temporarily stored amplitude of the carrier signal that has caused a rising edge or a falling edge in the corresponding logical output signal is switched by the multiplexer 20 through as the first intermediary signal $S_2$ to the calculation unit 3. The intermediary signal $S_2$ has a virtual amplitude with respect to the carrier signals generated by the carrier signal generator 16a, 16b, 16c, 16d.

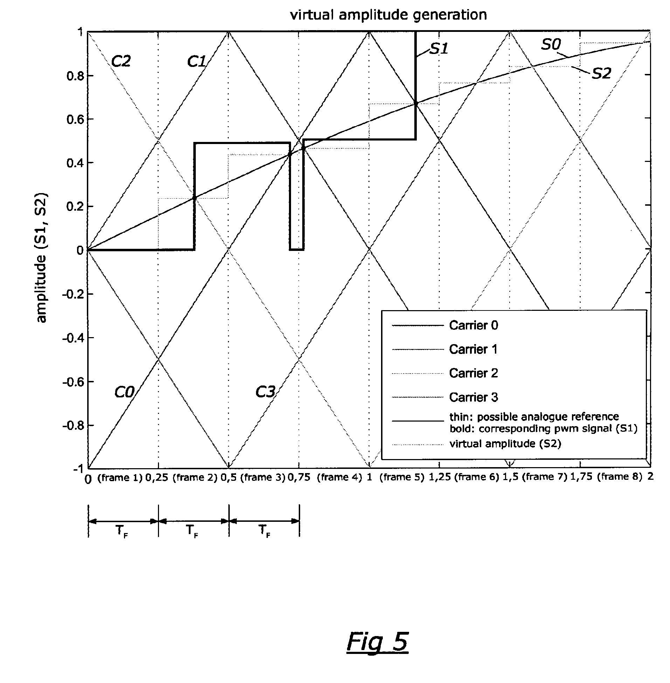

Figure 5 shows a generation of the first intermediary signal $S_2$ by the signal transformation unit 2 using four carrier signals CARRIERO, CARRIER1, CARRIER2, CARRIER3 generated by the carrier signal generator 16a, 16b, 16c, 16d, respectively.

The input signal $S_1$ consists of signal section each having a constant amplitude and can be any two-dimensional continuous time signal with at least two discrete amplitude values wherein the information is encoded into the amplitude and into the time location of the signal edges of this continuous time signal $S_1$. In figure 5, the continuous time input signal $S_1$ is shown as a bold line. By use of carriers $C_0$, $C_1$, $C_2$, $C_3$ which are in the given example triangular signals, the continuous time signal $S_1$ is transformed into the first intermediary signal $S_2$ having a virtual amplitude with respect to the carrier signals as shown in figure 5. In the given example, the input signal $S_1$ is generated by a signal source 8 in response to an analogue reference $S_0$ being a sine-wave signal. At each crossing point of the continuous time signal $S_1$ with a carrier C, a virtual amplitude of the intermediary signal $S_2$ is defined being constant for a time frame period $T_F$. The time frame is defined by the crossing of two carrier signals $C_i$, $C_j$ wherein the time frame period $T_F$ is given for a triangular signal as:

$$T_F = 1 / 2 \quad N_T \quad f_T,$$

Wherein $f_T$ is the frequency of the triangular carrier signal and $N_T$ is the number of carrier signals.

For a carrier signal that has a saw tooth form, the time frame period $T_F$ is given by:

$$T_F = 1 / N_T \quad f_T.$$

As can be seen from figure 5, the generated first intermediary signal $S_2$ is a one-dimensional continuous time signal with a virtual amplitude wherein the information carried by the two-dimensional input signal is now encoded only in one dimension, i. e. into the virtual amplitude of the first intermediary signal $S_2$. The intermediary signal $S_2$ consists of a plurality of signal sections having a constant amplitude wherein each of these signal sections has a constant time period $T_F$. This corresponds to a PCM signal when the amplitude of the intermediary signal $S_2$ is quantized. With the generated intermediary signal $S_2$ it is possible to perform mathematical operations without generating distortions in the calculated output signal.

Accordingly, the generated first intermediary signal $S_2$ is applied to a calculation unit 3 as shown in figure 2. The calculation unit 3 can perform any mathematical operation with the applied intermediary signal $S_2$,

such as subtracting or adding another signal. Another possibility is that the intermediary signal $S_2$ is multiplied with another signal or divided by another signal. It is also possible to perform more complex mathematical operations on the intermediary signal, such as calculating a square root etc. The calculation unit 3 may perform a mathematical operation only in response to the first intermediary signal $S_2$ or a mathematical operation with the first intermediary signal with at least another input signal $S_2'$. The second input signal $S_2'$ can be in a preferred embodiment a feedback signal of a feedback loop. The further input signal $S_2'$ consists also of signal sections wherein each signal section of said further input signal $S_2'$ has a constant amplitude. The input signal $S_2'$ is preferably a one-dimensional continuous time signal. Accordingly, the calculation unit 3 performs a mathematical operation of two one-dimensional continuous time signals to generate a second intermediary signal $S_3$ as the calculation result. The calculated resulting intermediary signal $S_2$ is applied to the retransformation unit 4 of the apparatus 1 as shown in figure 2.

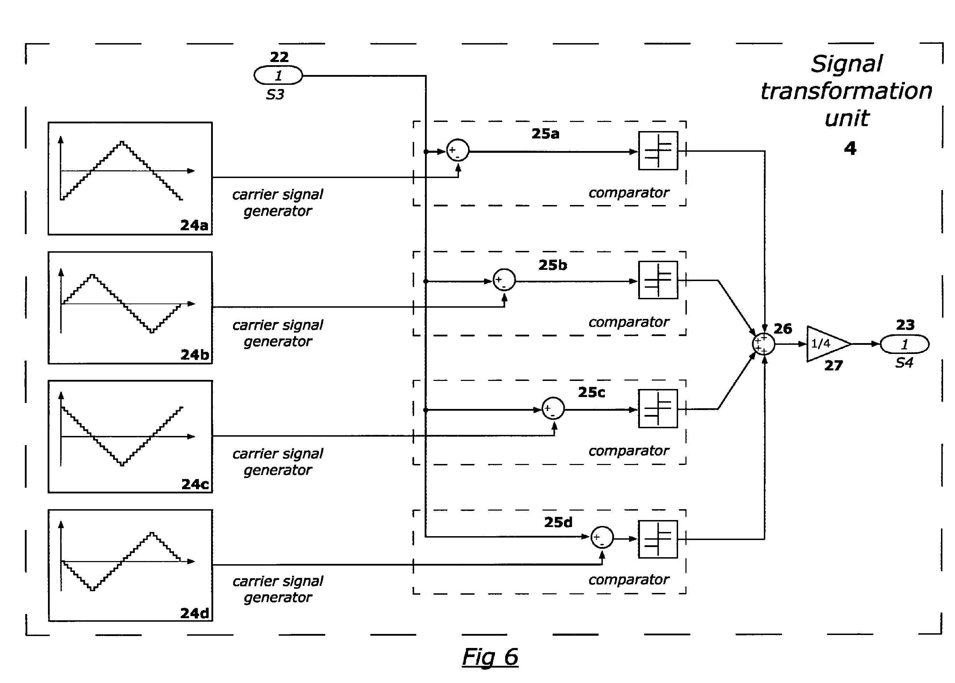

Figure 6 shows a possible embodiment of such a retransformation unit for retransforming the second intermediary signal $S_3$ into an output signal $S_4$. The signal retransformation unit 4 comprises an input 22 with an output 23 connected to the output 7 of the calculation apparatus 1. The retransformation unit 4 comprises carrier signal generators 24 provided for each carrier signal. For each carrier signal generator, a comparator 25 is provided which compares a second intermediary signal $S_3$ with the respective carrier signal to generate a corresponding comparator output signal. An adder 26 adds the comparator output signals to generate a sum signal which is scaled by a scaling unit 27 to generate the output signal of the calculation apparatus 1 according to the present invention. The output signal $S_4$ consists of signal sections wherein each signal section has a constant amplitude. The output signal $S_4$ can be a pulse-width modulated signal, a pulse-density modulated signal or a pulse-position modulated signal.

The carrier signal generator as employed in a signal transformation unit 2 and the signal retransformation unit 4 as shown in figures 4, 6 can be implemented by counters.

The calculation apparatus can be implemented as a hardware circuit. In an alternative embodiment, a microprocessor executes a program which performs the method according to the present invention.

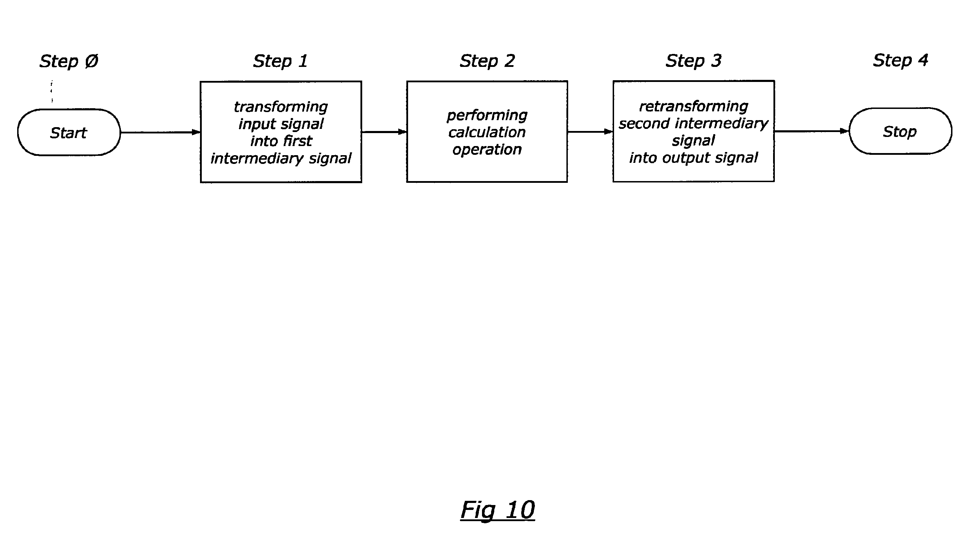

Figure 10 shows a flow chart of a possible embodiment of the method according to the present invention.

After a starting step $\theta$, the input signal $S_1$ is transformed in a step 1 into a first intermediary signal $S_2$ having a virtual amplitude with respect to a carrier signal. Then, the calculation operation on the first intermediary signal $S_2$ is performed to generate a second intermediary signal $S_3$ in a step 2. In a third method step, the second intermediary signal $S_3$ is retransformed to an output signal which consists of signal sections wherein each signal section of the output signal $S_4$ has a constant amplitude.

The calculation apparatus 1 as shown in figure 2 can be used in many devices, such as control loops, motor control circuits or digital amplifiers. The calculation apparatus according to the present invention can, in particular, be used for performing a mathematical operation with a feedback signal.

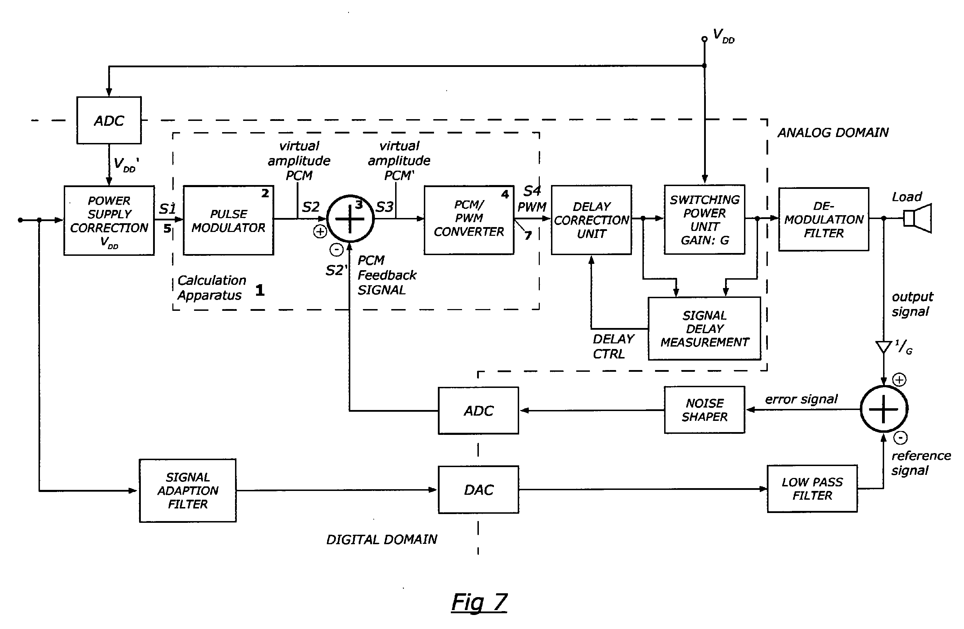

Figure 7 shows a possible use of the calculation apparatus 1 within a digital amplifier. In this example, the calculation unit 3 is formed by a subtractor subtracting a PCM feedback signal from the first intermediary signal $S_2$ generated by the signal transformation unit 2 being a pulse modulator.

Figure 7 shows a switching power amplifier which amplifies an input signal and outputs an amplified analogue signal at an output to a load, such as a loudspeaker. The input signal with the power amplifier is either analogue or digital.

The power amplifier as shown in figure 7 comprises a first signal path and a second reference signal path.

The first signal path comprises a power supply correction unit in a calculation apparatus 1 according to the present invention, a delay correction unit which compensates the variation of signal edges of the modulated signal, a switching power unit which amplifies the modulated signal to generate an amplified output signal, and finally, a demodulation filter which filters the amplified output signal generated by the switching power unit to generate an analogue output signal output to the load. Parallel to the switching power unit, a signal delay measurement unit is provided which measures the signal delays caused by the switching power unit to generate a delay control signal for the delay correction unit.

Besides the first signal path, a second signal path is provided within the switching power amplifier for generating a reference signal in response to the input signal applied to the signal input of the switching power amplifier. The second signal path comprises a digital adaption signal filter, a digital-to-analogue converter and an analogue low-pass filter. The digital-to-analogue converter comprises an over-sampling unit. Alternatively, the over-sampling is performed within in the digital signal adaption filter. The digital signal adaption filter causes preferably a delay for compensation of a delay intermediate signal path. The digital-to-analogue converter converts the filter digital input signal output by the signal adaption filter to generate an analogue signal which is filtered by a low-path filter to generate a reference signal.

The transfer function of the first signal path is equal to the transfer function of the reference signal path.

The switching power amplifier as shown in figure 7 including the calculation apparatus 1 has a sigmadelta feedback loop which comprises an analogue subtractor which subtracts from the output signal the reference signal, an analogue noise shaper for integrating the error signal and a quantizer for converting the integrated error signal into a digital feedback signal which is fed back to the first signal path, i. e. to the subtractor 3 of the calculation apparatus 1 according to the present invention.

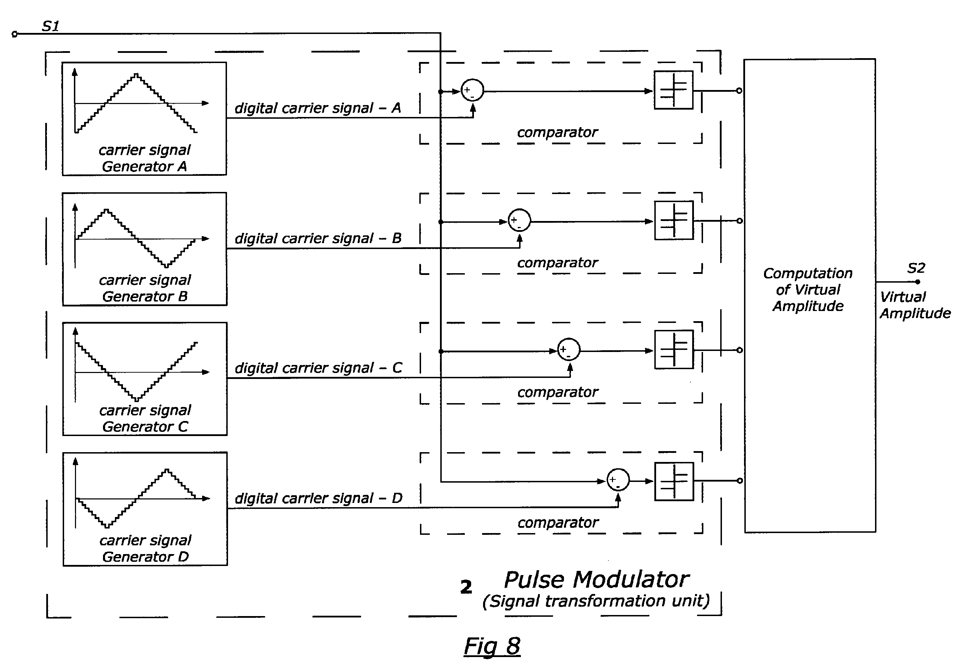

Figure 8 shows the pulse modulator 2 of the calculation apparatus 1 as shown in figure 7.

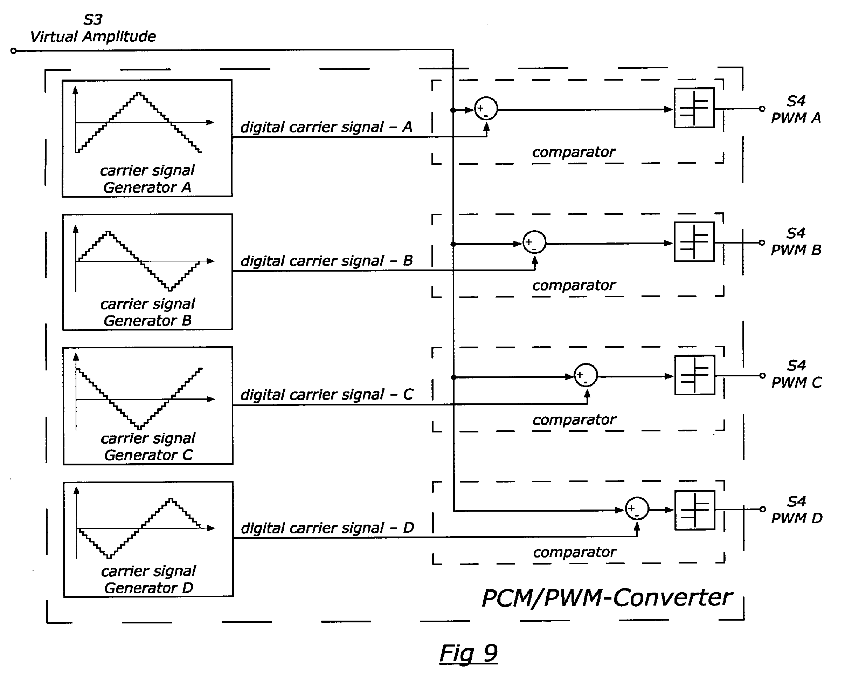

Figure 9 shows a block diagram of a PCM/PWM converter 4 of the calculation apparatus 1 according to the present invention as shown in figure 7.

The pulse-width modulated signal $S_4$ which forms the output signal of the calculation apparatus 1 according to the present invention does not contain distortions caused by the mathematical operation performed by the subtractor 3 within the calculation apparatus 1 as shown in figure 7. Any two-dimensional continuous time signal can be applied to the calculation apparatus 1 within the power amplifier as shown in figure 7. The input signal is a two-dimensional continuous time signal having information encoded in the amplitude and into the time of the signal. The pulse modulator 2 transforms the input signal into a first intermediate signal $S_2$ being a one-dimensional continuous time signal with a virtual amplitude wherein the information which originally was carried by the two-dimensional input signal $S_1$ is now encoded into the virtual amplitude of the first intermediate signal $S_2$. The first intermediate signal $S_2$ and the feedback signal $S_2$, are both one-dimensional continuous time signals allowing a distortion free mathematical operation by means of the calculation unit 3 which is formed in the given example by a subtractor.

## Claims

1. An apparatus for performing a calculation operation with at least one input signal consisting of signal sections, wherein each signal section of said input signal has a constant amplitude,
   said apparatus comprising:

   (a) a signal transformation unit (2) for transforming said at least one input signal ($S_1$) into a first intermediary signal ($S_2$), wherein the input signal ($S_1$) which consists of signal sections each having a constant amplitude is compared with the amplitude of generated carrier signals ($C_1$, $C_2$, ..., $C_n$) to generate corresponding logical output signals indicating whether the amplitude of the input signal ($S_1$) is higher than the amplitude of the respective carrier signal ($C_1$, $C_2$, ..., $C_N$), and wherein an amplitude of a temporarily stored carrier signal ($C_1$, $C_2$, ..., $C_N$) that caused a rising or a falling edge in the corresponding logical output signal is output as the first intermediary signal ($S_2$);
   (b) a calculation unit (3) for performing the calculation operation on said first intermediary signal ($S_2$) to generate a second intermediary sig-

nal (S$_3$);

(c) a signal retransformation unit (4) for retransforming said second intermediary signal (S$_3$) into an output signal consisting of signal (S$_4$)sections, wherein each signal section of said output signal has a constant amplitude.

2. The apparatus according to claim 1, wherein said input signal (S$_1$) is a two-dimensional time signal with at least two different amplitude values, wherein information is encoded into the amplitude values and into the time location of signal edges of said time signal.

3. The apparatus according to claim 1, wherein said first intermediary signal (S$_2$) is a one-dimensional time signal.

4. The apparatus according to claim 1, wherein said second intermediary signal (S$_3$) is a one-dimensional time signal.

5. The apparatus according to claim 1, wherein the calculation unit (3) receives said first intermediary signal (S$_2$) from said signal transformation unit (2) and performs the calculation operation with the first intermediary signal (S$_2$) and if appropriate with one or more further input signals (S$_2$', S$_2$", ......).

6. The apparatus according to claim 5, wherein said further input signal (S$_2$,) consists of signal sections, wherein each signal section of said further input signal (S$_2$') has a constant amplitude.

7. The apparatus according to claim 5, wherein said further input signal (S$_2$,) is a one-dimensional time signal.

8. The apparatus according to claim 1, wherein said signal transformation unit (2) comprises: a carrier signal generator (16) for each carrier signal (C$_1$, C$_2$, ..., C$_N$) to generate said carrier signal.

9. The apparatus according to claim 1, wherein said signal transformation unit (2) comprises:

a comparator (17) for each carrier signal generator (16) which compares the amplitude of said input signal (S$_1$) with the amplitude of said generated carrier signal to generate a logical output signal indicating whether the amplitude of said input signal (S$_1$) is higher than the amplitude of said carrier signal.

10. The apparatus according to claim 9,

wherein said signal transformation unit (2) further comprises:

a sample-and-hold circuit (18) for each comparator (17) which is triggered by said logical output signal of the respective comparator (17) to store temporarily the amplitude of the respective carrier signal at an output terminal of said sample-and-hold circuit (18).

11. The apparatus according to claim 10, wherein said sample-and-hold circuit (18) is triggered by a rising edge or by a falling edge of said logical signal output at an output terminal of the respective comparator (17).

12. The apparatus according to claim 10, wherein said signal transformation unit (2) further comprises:

a detector circuit (21) which is connected to the output terminals of the comparators (17) and receives the logical output signals of said comparators (17) to detect which carrier signal (C$_1$, C$_2$, ..., C$_N$) has caused a rising edge or a falling edge of a logical output signal.

13. The apparatus according to claim 12, wherein said signal transmission unit (2) further comprises:

a multiplexer (20) which is controlled by said detector circuit (21) and which has several inputs connected to the output terminals of said sample-and-hold circuit (18).

14. The apparatus according to claim 13, wherein the temporarily stored amplitude of the carrier signal detected by said detector circuit (21) is switched by said multiplexer (20) through as the first intermediary signal (S$_2$) to said calculation unit (3).

15. The apparatus according to claim 8, wherein each carrier signal generator (16) generates a periodic triangular signal.

16. The apparatus according to claim 8, wherein each carrier signal generator (16) generates a periodic saw tooth signal.

17. The apparatus according to claim 15 or claim 16, wherein the carrier signal generator (16) is formed by a counter.

18. The apparatus according to claim 1, wherein the generated carrier signals (C$_1$, C$_2$, ..., C$_N$) are phase shifted with respect to each other.

**19.** The apparatus according to claim 18, wherein the phase shift between two carrier signals ($C_1$, $C_2$, ..., $C_N$) is 360° divided by a number N of provided carrier signals.

**20.** The apparatus according to claim 1, wherein said calculation unit (3) is a subtractor for subtracting a feedback signal from said first intermediary signal ($S_2$) to generate said second intermediary signal ($S_3$).

**21.** The apparatus according to claim 1, wherein said calculation unit (3) performs a selectable calculation operation.

**22.** The apparatus according to claim 1, wherein said input signal ($S_1$) is generated by a signal source (8).

**23.** The apparatus according to claim 22, wherein said signal source (8) generates said input signal in response to an analogue signal ($S_\varphi$).

**24.** The apparatus according to claim 22, wherein said signal source (8) generates said input signal in response to a PCM signal ($S_\varphi$).

**25.** The apparatus according to claim 1, wherein said signal retransformation unit (4) comprises:

an input terminal (22) for receiving said second intermediary signal ($S_3$) from said calculation unit (3);
a carrier signal generator (24) provided for each carrier signal;
a comparator (25) for each carrier signal generator (24) which compares said second intermediary signal ($S_3$) with the respective carrier signal to generate a corresponding comparator output signal;
an adder (26) for adding the comparator output signals to generate a sum signal;
a scaling unit (27) for scaling the generated sum signal;
an output terminal (23) to output the scaled sum signal as the output signal ($S_4$) of said apparatus.

**26.** The apparatus according to claim 1, wherein said input signal ($S_1$) is a pulse width modulated signal.

**27.** The apparatus according to claim 1, wherein said output signal is a pulse width modulated signal ($S_4$).

**28.** The apparatus according to claim 1,

wherein said input signal ($S_1$) is a pulse density modulated signal.

**29.** The apparatus according to claim 1, wherein said output signal ($S_4$) is a pulse density modulated signal.

**30.** The apparatus according to claim 1, wherein the input signal ($S_4$) is a pulse position modulated signal.

**31.** The apparatus according to claim 1, wherein the output signal ($S_4$) is pulse position modulated signal.

**32.** A method for performing a calculation operation with at least one input signal ($S_1$) consisting of signal sections, wherein each signal section of said input signal has a constant amplitude,
said method comprising the following steps:

(a) transforming said input signal ($S_1$) into a first intermediary signal ($S_2$), wherein the input signal ($S_1$) which consists of signal sections each having a constant amplitude is compared with the amplitude of generated carrier signals ($C_1$, $C_2$, ..., $C_N$) to generate corresponding logical output signals indicating whether the amplitude of the input signal ($S_1$) is higher than the amplitude of the respective carrier signal ($C_1$, $C_2$, ..., $C_N$), and wherein an amplitude of a temporarily stored carrier signal ($C_1$, $C_2$, ..., $C_N$) that caused a rising or a falling edge in the corresponding logical output signal is output as the first intermediary signal ($S_2$);
(b) performing the calculation operation on said first intermediary signal ($S_2$) to generate a second intermediary signal ($S_3$) ;
(c) retransforming said second intermediary signal ($S_3'$) into an output signal ($S_4$) consisting of signal sections, wherein each signal section of said output signal has a constant amplitude.

**33.** Computer program for performing the method according to claim 32.

**34.** Data carrier storing a computer program which performs the method according to claim 32.

**Patentansprüche**

**1.** Vorrichtung zur Durchführung einer Rechenoperation mit mindestens einem Eingangssignal, das aus Signalabschnitten besteht, wobei jeder Signalabschnitt des Eingangssignals eine konstante Amplitude aufweist, wobei die Vorrichtung aufweist:

(a) eine Signalumwandlungseinheit (2) zum Umwandeln des mindestens einen Eingangssignals ($S_1$) in ein erstes Zwischensignal ($S_2$), wobei das Eingangssignal ($S_1$), welches aus Signalabschnitten besteht, die jeweils eine konstante Amplitude aufweisen, mit der Amplitude von erzeugten Trägersignalen ($C_1$, $C_2$, ..., $C_N$) verglichen wird, um entsprechende logische Ausgangssignale zu erzeugen, die anzeigen, ob die Amplitude des Eingangssignals ($S_1$) höher ist als die Amplitude des jeweiligen Trägersignals ($C_1$, $C_2$, ..., $C_N$), und wobei eine Amplitude eines vorübergehend gespeicherten Trägersignals ($C_1$, $C_2$, ..., $C_N$), die eine Anstiegflanke oder eine Abstiegflanke in dem entsprechenden logischen Ausgangssignal verursacht hat, als das erste Zwischensignal ($S_2$) ausgegeben wird;

(b) eine Recheneinheit (3) zum Durchführen der Rechenoperation an dem ersten Zwischensignal ($S_2$), um ein zweites Zwischensignal ($S_3$) zu erzeugen;

(c) eine Signalzurückwandlungseinheit (4) zum Zurückwandeln des zweiten Zwischensignals ($S_3$) in ein Ausgangssignal, das aus Signal-($S_4$)-Abschnitten besteht, wobei jeder Signalabschnitt des Ausgangssignals eine konstante Amplitude aufweist.

2. Vorrichtung nach Anspruch 1, wobei das Eingangssignal ($S_1$) ein zweidimensionales Zeitsignal mit mindestens zwei verschiedenen Amplitudenwerten ist, wobei Informationen in die Amplitudenwerte und in die zeitliche Anordnung von Signalflanken des Zeitsignals verschlüsselt werden.

3. Vorrichtung nach Anspruch 1, wobei das erste Zwischensignal (S2) ein eindimensionales Zeitsignal ist.

4. Vorrichtung nach Anspruch 1, wobei das zweite Zwischensignal (S3) ein eindimensionales Zeitsignal ist.

5. Vorrichtung nach Anspruch 1, wobei die Recheneinheit (3) das erste Zwischensignal ($S_2$) von der Signalumwandlungseinheit (2) empfängt und die Rechenoperation mit dem ersten Zwischensignal ($S_2$), und gegebenenfalls mit einem oder mehreren weiteren Eingangssignalen ($S_{2'}$, $S_{2''}$, ...) durchführt.

6. Vorrichtung nach Anspruch 5, wobei das weitere Eingangssignal ($S_{2'}$) aus Signalabschnitten besteht, wobei jeder Signalabschnitt des weiteren Eingangssignals ($S_{2'}$) eine konstante Amplitude aufweist.

7. Vorrichtung nach Anspruch 5, wobei das weitere Eingangssignal ($S_{2'}$) ein eindimensionales Zeitsignal ist.

8. Vorrichtung nach Anspruch 1, wobei die Signalumwandlungseinheit (2) aufweist:

- einen Trägersignalgenerator (16) für jedes Trägersignal ($C_1$, $C_2$, ..., $C_N$), um das Trägersignal zu erzeugen.

9. Vorrichtung nach Anspruch 1, wobei die Signalumwandlungseinheit (2) aufweist:

- ein Vergleichsprogramm (17) für jeden Trägersignalgenerator (16), das die Amplitude des Eingangssignals ($S_1$) mit der Amplitude des erzeugten Trägersignals vergleicht, um ein logisches Ausgangssignal zu erzeugen, welches anzeigt, ob die Amplitude des Eingangssignals ($S_1$) höher ist als die Amplitude des Trägersignals.

10. Vorrichtung nach Anspruch 9, wobei die Signalumwandlungseinheit (2) ferner aufweist:

- eine Abtast-Halte-Schaltung (18) für jedes Vergleichsprogramm (17), die durch das logische Ausgangssignal des jeweiligen Vergleichsprogramms (17) ausgelöst wird, um die Amplitude des jeweiligen Trägersignals an einer Ausgangsklemme der Abtast-Halte-Schaltung (18) vorübergehend zu speichern.

11. Vorrichtung nach Anspruch 10, wobei die Abtast-Halte-Schaltung (18) durch eine Anstiegflanke oder durch eine Abstiegflanke des logischen Signalausgangs an einer Ausgangsklemme des jeweiligen Vergleichsprogramms (17) ausgelöst wird.

12. Vorrichtung nach Anspruch 10, wobei die Signalumwandlungseinheit (2) ferner aufweist:

- eine Detektorschaltung (21), die an die Ausgangsklemmen der Vergleichsprogramme (17) angeschlossen ist und die logischen Ausgangssignale der Vergleichsprogramme (17) empfängt, um zu erkennen, welches Trägersignal ($C_1$, $C_2$, ..., $C_N$) eine Anstiegflanke oder eine Abstiegflanke eines logischen Ausgangssignals verursacht hat.

13. Vorrichtung nach Anspruch 12, wobei die Signalumwandlungseinheit (2) ferner aufweist:

- ein Multiplexgerät (20), welches durch die Detektorschaltung (21) gesteuert wird und mehrere Eingänge aufweist, die mit den Ausgangsklemmen der Abtast-Halte-Schaltung (18) verbunden sind.

**14.** Vorrichtung nach Anspruch 13, wobei die vorübergehend gespeicherte Amplitude des von der Detektorschaltung (21) erfassten Trägersignals durch das Multiplexgerät (20) als das erste Zwischensignal ($S_2$) zur Recheneinheit (3) durchgeschaltet wird.

**15.** Vorrichtung nach Anspruch 8, wobei jeder Trägersignalgenerator (16) ein periodisches Dreiecksignal erzeugt.

**16.** Vorrichtung nach Anspruch 8, wobei jeder Trägersignalgenerator (16) ein periodisches Sägezahnsignal erzeugt.

**17.** Vorrichtung nach Anspruch 15 oder 16, wobei der Trägersignalgenerator (16) durch einen Zähler gebildet ist.

**18.** Vorrichtung nach Anspruch 1, wobei die erzeugten Trägersignale ($C_1$, $C_2$, ..., $C_N$) zueinander phasenverschoben sind.

**19.** Vorrichtung nach Anspruch 18, wobei die Phasenverschiebung zwischen zwei Trägersignalen ($C_1$, $C_2$, ..., $C_N$) 360 ° geteilt durch eine Zahl N von vorgesehenen Trägersignalen ist.

**20.** Vorrichtung nach Anspruch 1, wobei die Recheneinheit (3) ein Subtrahierer zum Subtrahieren eines Rückkopplungssignals von dem ersten Zwischensignal ($S_2$) ist, um das zweite Zwischensignal ($S_3$) zu erzeugen.

**21.** Vorrichtung nach Anspruch 1, wobei die Recheneinheit (3) eine auswählbare Rechenoperation durchführt.

**22.** Vorrichtung nach Anspruch 1, wobei das Eingangssignal ($S_1$) durch eine Signalquelle (8) erzeugt wird.

**23.** Vorrichtung nach Anspruch 22, wobei die Signalquelle (8) das Eingangssignal in Abhängigkeit eines Analogsignals ($S_\varphi$) erzeugt.

**24.** Vorrichtung nach Anspruch 22, wobei die Signalquelle (8) das Eingangssignal in Abhängigkeit eines PCM-Signals ($S_\varphi$) erzeugt.

**25.** Vorrichtung nach Anspruch 1, wobei die Signalzurückwandlungseinheit (4) aufweist:

- eine Eingangsklemme (22) zum Empfangen des zweiten Zwischensignals ($S_3$) von der Recheneinheit (3); einen Trägersignalgenerator (24), der für jedes Trägersignal vorgesehen ist;
- ein Vergleichsprogramm (25) für jeden Trägersignalgenerator (24), der das zweite Zwischensignal ($S_3$) mit dem jeweiligen Trägersignal vergleicht, um ein entsprechendes Vergleichsprogramm-Ausgangssignal zu erzeugen;
- einen Addierer (26) zum Addieren der Vergleichsprogramm-Ausgangssignale, um ein Summensignal zu erzeugen;
- eine Skalierungseinheit (27) zum Skalieren des erzeugten Summensignals;
- eine Ausgangsklemme (23), um das skalierte Summensignal als das Ausgangssignal ($S_4$) der Vorrichtung auszugeben.

**26.** Vorrichtung nach Anspruch 1, wobei das Eingangssignal ($S_1$) ein pulsweitemoduliertes Signal ist.

**27.** Vorrichtung nach Anspruch 1, wobei das Ausgangssignal ein pulsweitemoduliertes Signal ($S_4$) ist.

**28.** Vorrichtung nach Anspruch 1, wobei das Eingangssignal ($S_1$) ein pulsdichtemoduliertes Signal ist.

**29.** Vorrichtung nach Anspruch 1, wobei das Ausgangssignal ($S_4$) ein pulsdichtemoduliertes Signal ist.

**30.** Vorrichtung nach Anspruch 1, wobei das Eingangssignal ($S_4$) ein pulspositionsmoduliertes Signal ist.

**31.** Vorrichtung nach Anspruch 1, wobei das Ausgangssignal ($S_4$) ein pulspositionsmoduliertes Signal ist.

**32.** Verfahren zur Durchführung einer Rechenoperation mit mindestens einem Eingangssignal ($S_1$), das aus Signalabschnitten besteht, wobei jeder Signalabschnitt des Eingangssignals eine konstante Amplitude aufweist, wobei das Verfahren die folgenden Schritte aufweist:

(a) Umwandeln des Eingangssignals ($S_1$) in ein erstes Zwischensignal ($S_2$), wobei das Eingangssignal ($S_1$), welches aus Signalabschnitten besteht, die jeweils eine konstante Amplitude aufweisen, mit der Amplitude von erzeugten Trägersignalen ($C_1$, $C_2$, ..., $C_N$) verglichen wird, um entsprechende logische Ausgangssignale zu erzeugen, die anzeigen, ob die Amplitude des Eingangssignals ($S_1$) höher ist als die Amplitude des jeweiligen Trägersignals ($C_1$, $C_2$, ..., $C_N$), und wobei eine Amplitude eines vorübergehend gespeicherten Trägersignals ($C_1$, $C_2$, ..., $C_N$), die eine Anstiegflanke oder eine Abstiegflanke in dem entsprechenden logischen Ausgangssignal verursacht hat, als das erste Zwischensignal ($S_2$) ausgegeben wird;
(b) Durchführen der Rechenoperation an dem ersten Zwischensignal ($S_2$), um ein zweites Zwischensignal ($S_3$) zu erzeugen
(c) Zurückwandeln des zweiten Zwischensignals ($S_{3'}$) in ein Ausgangssignal ($S_4$), das aus Signalabschnitten besteht, wobei jeder Signalabschnitt des Ausgangssignals eine konstante Amplitude aufweist.

**33.** Computerprogramm zum Durchführen des Verfahrens nach Anspruch 32.

**34.** Datenträger, der ein Computerprogramm speichert, welches das Verfahren nach Anspruch 32 durchführt.

## Revendications

**1.** Appareil de réalisation d'une opération de calcul avec au moins un signal d'entrée consistant en des sections de signal, dans lequel chaque section de signal dudit signal d'entrée présente une amplitude constante, ledit appareil comprenant :

(a) une unité de transformation de signal (2) destinée à transformer au moins un signal d'entrée ($S_1$) en un premier signal intermédiaire ($S_2$), dans lequel le signal d'entrée ($S_1$) qui consiste en des sections de signal ayant chacune une amplitude constante est comparé avec l'amplitude de signaux porteurs générés ($C_1$, $C_2$, ..., $C_N$) pour générer les signaux de sortie logique correspondants indiquant si l'amplitude du signal d'entrée ($S_1$) est supérieure à l'amplitude du signal porteur respectif ($C_1$, $C_2$, ..., $C_N$), et dans lequel une amplitude d'un signal porteur stocké temporairement ($C_1$, $C_2$, ..., $C_N$) qui a causé un front montant ou un font descendant dans le signal de sortie logique est sortie comme le premier signal intermédiaire ($S_2$) ;
(b) une unité de calcul (3) destinée à réaliser l'opération de calcul sur ledit premier signal intermédiaire ($S_2$) pour générer un second signal intermédiaire ($S_3$) ;
(c) une unité de retransformation de signal (4) destinée à retransformer ledit second signal intermédiaire ($S_3$) en un signal de sortie consistant en sections de signal ($S_4$), dans lequel chaque section de signal dudit signal de sortie présente une amplitude constante.

**2.** Appareil selon la revendication 1, dans lequel ledit signal d'entrée ($S_1$) est un signal temporel bidimensionnel doté d'au moins deux différentes valeurs d'amplitude, dans lequel l'information est codée en des valeurs d'amplitude et en position temporelle de fronts de signaux dudit signal temporel.

**3.** Appareil selon la revendication 1, dans lequel ledit premier signal intermédiaire ($S_2$) est un signal temporel monodimensionnel.

**4.** Appareil selon la revendication 1, dans lequel ledit second signal intermédiaire ($S_3$) est un signal temporel monodimensionnel.

**5.** Appareil selon la revendication 1, dans lequel l'unité de calcul (3) reçoit ledit premier signal intermédiaire ($S_2$) de ladite unité de transformation de signal (2) et réalise l'opération de calcul avec le premier signal intermédiaire ($S_2$) et le cas échéant avec un ou plusieurs signaux d'entrée supplémentaires ($S_{2'}$, $S_{2''}$, ...).

**6.** Appareil selon la revendication 5, dans lequel ledit signal d'entrée supplémentaire ($S_{2'}$) consiste en des sections de signal, dans lequel chaque section de signal dudit signal d'entrée supplémentaire ($S_{2'}$) présente une amplitude constante.

**7.** Appareil selon la revendication 5, dans lequel ledit signal d'entrée supplémentaire ($S_2$) est un signal temporel monodimensionnel.

**8.** Appareil selon la revendication 1, dans lequel l'unité de transformation de signal (2) comprend : un générateur de signal porteur (16) pour chaque signal porteur ($C_1$, $C_2$, ..., $C_N$) pour générer ledit signal porteur.

**9.** Appareil selon la revendication 1, dans lequel ladite unité de transformation de signal (2) comprend :

- un comparateur (17) pour chaque générateur de signal porteur (16) qui compare l'amplitude dudit signal d'entrée ($S_1$) avec l'amplitude dudit signal porteur généré pour générer un signal de sortie logique indiquant si l'amplitude dudit signal d'entrée ($S_1$) est supérieure à l'amplitude dudit signal porteur.

**10.** Appareil selon la revendication 9, dans lequel ladite unité de transformation de signal (2) comprend en outre :

- un échantillonneur-bloqueur (18) pour chaque comparateur (17) qui est déclenché par ledit signal de sortie logique du comparateur respectif (17) pour stocker temporairement l'amplitude du signal porteur respectif au niveau d'une borne de sortie dudit échantillonneur-bloqueur (18).

**11.** Appareil selon la revendication 10, dans lequel ledit échantillonneur-bloqueur (18) est déclenché par un front montant ou par un front descendant de ladite sortie de signal logique au niveau d'une borne de sortie du comparateur respectif (17).

**12.** Appareil selon la revendication 10, dans lequel ladite unité de transformation de signal (2) comprend en

**11**

outre :

- un circuit de détection (21) qui est relié aux bornes des comparateurs (17) et reçoit les signaux de sortie logique desdits comparateurs (17) pour détecter quel signal porteur ($C_1$, $C_2$, ..., $C_N$) a causé un front montant ou un front descendant d'un signal de sortie logique.

**13.** Appareil selon la revendication 12, dans lequel ladite unité de transformation de signal (2) comprend en outre :

- un multiplexeur (20) qui est commandé par ledit circuit de détection (21) et qui a plusieurs entrées reliées aux bornes de sortie dudit échantillonneur-bloqueur (18).

**14.** Appareil selon la revendication 13, dans lequel l'amplitude stockée temporairement du signal porteur détecté par ledit circuit de détection (21) est commutée par ledit multiplexeur (20) en tant que premier signal intermédiaire ($S_2$) à ladite unité de calcul (3).

**15.** Appareil selon la revendication 8, dans lequel chaque générateur de signal porteur (16) génère un signal triangulaire périodique.

**16.** Appareil selon la revendication 8, dans lequel chaque générateur de signal porteur (16) génère un signal en dents de scie périodique.

**17.** Appareil selon la revendication 15 ou la revendication 16, dans lequel le générateur de signal porteur (16) est formé par un compteur.

**18.** Appareil selon la revendication 1, dans lequel les phases des signaux porteurs générés ($C_1$, $C_2$, ..., $C_N$) sont décalées les unes par rapport aux autres.

**19.** Appareil selon la revendication 18, dans lequel le décalage de phase entre deux signaux porteurs ($C_1$, $C_2$, ..., $C_N$) est de 360° divisés en un nombre N de signaux porteurs fournis.

**20.** Appareil selon la revendication 1, dans lequel ladite unité de calcul (3) est un soustracteur destiné à soustraire un signal de retour dudit premier signal intermédiaire ($S_2$) pour générer ledit second signal intermédiaire ($S_3$).

**21.** Appareil selon la revendication 1, dans lequel ladite unité de calcul (3) réalise une opération de calcul sélectionnable.

**22.** Appareil selon la revendication 1, dans lequel ledit signal d'entrée ($S_1$) est généré par une source de signal (8).

**23.** Appareil selon la revendication 22, dans lequel ladite source de signal (8) génère ledit signal d'entrée en réponse à un signal analogique ($S_\varphi$).

**24.** Appareil selon la revendication 22, dans lequel ladite source de signal (8) génère ledit signal d'entrée en réponse à un signal MIC ($S_\varphi$).

**25.** Appareil selon la revendication 1, dans lequel ladite unité de retransformation de signal (4) comprend :

- une borne d'entrée (22) destinée à recevoir ledit second signal intermédiaire ($S_3$) provenant de ladite unité de calcul (3) ;
- un générateur de signaux porteurs (24) fourni pour chaque signal porteur ;
- un comparateur (25) pour chaque générateur de signal porteur (24) qui compare ledit second signal intermédiaire ($S_3$) avec ledit signal porteur respectif pour générer un signal de sortie du comparateur correspondant ;
- un additionneur (26) destiné à additionner les signaux de sortie du comparateur pour générer un signal somme ;
- une unité d'échelonnage (27) destinée à échelonner le signal somme généré ;
- une borne de sortie (23) pour sortir le signal somme échelonné comme le signal de sortie ($S_4$) dudit appareil.

**26.** Appareil selon la revendication 1, dans lequel ledit signal d'entrée ($S_1$) est un signal modulé à largeur d'impulsion.

**27.** Appareil selon la revendication 1, dans lequel ledit signal de sortie est un signal modulé à largeur d'impulsion ($S_4$).

**28.** Appareil selon la revendication 1, dans lequel ledit signal d'entrée ($S_1$) est un signal modulé à densité d'impulsion.

**29.** Appareil selon la revendication 1, dans lequel ledit signal de sortie ($S_4$) est un signal modulé à densité d'impulsion.

**30.** Appareil selon la revendication 1, dans lequel le signal d'entrée ($S_4$) est un signal modulé à position d'impulsion.

**31.** Appareil selon la revendication 1, dans lequel le signal de sortie ($S_4$) est un signal modulé à position d'impulsion.

**32.** Procédé de réalisation d'une opération de calcul avec au moins un signal d'entrée ($S_1$) consistant en des sections de signal, dans lequel chaque section de signal dudit signal d'entrée présente une amplitude constante, ledit procédé comportant les étapes suivantes :

(a) transformation dudit signal d'entrée ($S_1$) en un premier signal intermédiaire ($S_2$), dans laquelle le signal d'entrée ($S_1$) qui consiste en des sections de signal ayant chacune une amplitude constante est comparé avec l'amplitude des signaux porteurs générés ($C_1$, $C_2$, ..., $C_N$) pour générer des signaux de sortie logique correspondants indiquant si l'amplitude du signal d'entrée ($S_1$) est supérieure à l'amplitude du signal porteur respectif ($C_1$, $C_2$, ..., $C_N$), et dans laquelle une amplitude d'un signal porteur stocké temporairement ($C_1$, $C_2$, ..., $C_N$) qui a causé un front montant ou un font descendant dans le signal de sortie logique est sortie comme le premier signal intermédiaire ($S_2$) ;
(b) réalisation de l'opération de calcul sur ledit premier signal intermédiaire ($S_2$) pour générer un second signal intermédiaire ($S_3$) ;
(c) retransformation dudit second signal intermédiaire ($S_{3'}$) en un signal de sortie ($S_4$) consistant en des sections de signal, dans lequel chaque section de signal dudit signal de sortie présente une amplitude constante.

33. Programme informatique destiné à réaliser le procédé selon la revendication 32.

34. Support de données stockant un programme informatique destiné à réaliser le procédé selon la revendication 32.

**1A** Pulse Amplitude Modulation (PAM)

**1B** Pulse Position Modulation (PPM)

**1C** Pulse Width Modulation (PWM)

**1D** Pulse Density Modulation (PDM)

*state of the art*

*Fig 1*
*PULSE MODULATION METHODS*

EP 1 858 159 B1

*Fig 2*

Fig 3

Signal transformation unit **2**

S2 — Virtual Amplitude **1**

MUX **20** — Control — S2

Carrier Number **21** — In 0, In 1, In 2, In 3 — Determine Carrier that sampled input signal

19a, 19b, 19c, 19d

In S/H **18a** — Sample and Hold 0 — **17a**
In S/H **18b** — Sample and Hold 1 — **17b**
In S/H **18c** — Sample and Hold 2 — **17c**
In S/H **18d** — Sample and Hold 3 — **17d**

**1** S1 — PWM Input signal

**16a** **16b** **16c** **16d** — carrier signals

*Fig 4*

EP 1 858 159 B1

virtual amplitude generation

| | Carrier 0 |
| | Carrier 1 |
| | Carrier 2 |
| | Carrier 3 |
| | thin: possible analogue reference bold: corresponding pwm signal (S1) |
| | virtual amplitude (S2) |

_Fig 5_

Fig 6

_Fig 7_

EP 1 858 159 B1

**Pulse Modulator**
*(Signal transformation unit)* 2

_Fig 8_

EP 1 858 159 B1

Fig 9

     Step 1      Step 2      Step 3      Step 4

Start

transforming
input signal
into first
intermediary signal

performing
calculation
operation

retransforming
second intermediary
signal
into output signal

Stop

_Fig 10_

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1653604 A
- EP 1653605 A
- US 6586991 B
- US 5592559 A
- US 5617058 A
- US 6473457 B